# EUROPEAN PATENT APPLICATION

(11) **EP 1 985 584 A1**
(43) Date of publication of application: **29.10.2008**
(21) Application number: 07709564.4
(22) Date of filing: 10.01.2007
(51) Int. Cl.: C01B 31/02, C23C 14/16, C23C 14/24, C23C 16/06, C23C 16/26

(54) **METHOD FOR PRODUCING A CARBON-CONTAINING MATERIAL BY CARBON ELECTRON-BEAM VAPORISATION IN A VACUUM AND A SUBSEQUENT CONDENSATION THEREOF ON A SUBSTRATE AND A DEVICE FOR CARRYING OUT SAID METHOD**

(30) Priority: 13.01.2006 UA 2006000342
(71) Applicant: National Academy of Sciences of Ukraine, ul.Gorkogo 68 Kiev, 03150 (UA)
(72) Inventor: PATON, Boris, Kiev, 01034 (UA); MOVCHAN, Boris, Kiev, 01094 (UA); KURAPOV, Iurii, Kiev, 03022 (UA); YAKOVCHUK, Konstantin, Kiev, 03124 (UA)
(74) Representative: Savolainen, Seppo Kalevi
(86) International application number: PCT/UA2007/000002
(87) International publication number: WO 2007/081298

(57) **Abstract**

The invention relates to a method for producing a carbon-containing material by the carbon or carbon and another component electron-beam vaporization in vacuum and by the consequent condensation thereof consisting in reflecting a carbon vapour flow with the aid of a reflector at least once on a path between a crucible and the substrate, in capturing atoms and clusrers of a transition metal, in directing the pure carbon vapour flow to the substrate, wherein it meets the vapour flow of a second organic or non-organic component, and in condensing in the substrate heating and/or cooling conditions. When required, a mixture of several neutral or reaction gases is supplied to a vacuum condensation chamber/area. The invention device for producing a carbon-containing material by the carbon or carbon and another component electron-beam vaporization in a vacuum and by consequent condensation thereof comprises at least one reflector for capturing heavy atoms and clusters of the transition metal and a gas supply inlet valve unit, thereby making it possible to obtain the pure vapour flow of carbon or the carbon with the added second organic or non-organic component and to condense it on the solid or liquid surface of the substrate by heating/cooling said surface and, when, necessary, by supplying corresponding gases for obtaining especially pure carbon-containing materials and for synthesizing novel nanomaterials.

## Description

### Field of the invention

The invention relates to the area of producing coatings and synthesis of new materials in vacuum and can be applied in tool industry, electronic, medicine, as well as producing very-high-purity nanomaterials.

### Prior art

Known are the methods to produce dense carbon coatings practically at any substrate temperature. These are methods of physical deposition from the vapour phase (PVD).

For instance, evaporation of carbon due to erosion of a graphite cathode in self-sustained arc discharge can be the method of producing carbon coatings [Strelnitskii V.E., Padalka V.G., Vakula S.I. Some properties of diamondlike carbon films obtained at plasma flow condensation under the conditions of application of a high-frequency potential. - Zhumal tekhnichnoji fiziky, 1978, v. 48, iss.2, p. 377-381]. This method allows to obtain coatings in a broad range of temperatures of substrates, including water-cooled substrates. The rate of coating deposition reaches 10 µm/h. However, the high density of current on the graphite electrode promotes ejection of microparticles, which impair the coating property and do not allow to increase the process efficiency. This is associated with the fact that carbon evaporates without formation of a liquid pool, i.e. it sublimates. In this case, the evaporation process is essentially influenced by the features of graphite structure, in particular, its layered structure. The weak bond between the layers increases the probability of graphite delamination into flakes.

The closest prior art to the process of producing carbon-containing material by the method of electron beam evaporation of carbon in vacuum with its subsequent condensation on the substrate that can be mentioned is disclosed in US Patent # 5296274, cl B05D 1/00, Movchan B.A. "Method of producing carbon-containing materials by electron beam vacuum evaporation of graphite and subsequent condensation", process of producing carbon-containing material by the method of electron beam evaporation of carbon under vacuum with subsequent condensation on a substrate, which includes placing graphite or graphite and at least one other organic or non-organic component in the vacuum chamber, placing a sample of at least one transition metal of groups VI - VIII of the periodic system on the consumed graphite surface, electron beam heating and melting of the above sample, heating and evaporation of graphite or graphite and at least one other organic or non-organic component through a molten pool of the sample, feeding graphite and the sample material and at least one additional organic or non-organic component into the evaporation zone, vapour flow ionization in the arc discharge, acceleration of ions that form, and condensation of carbon-containing material on the substrate. In this case melted on the graphite rod surface is a sample, which consists of, at least, one of such elements as tungsten and molybdenum, up to a melt formation. Presence of the melt of substances with a lower vapour pressure than that of carbon ensures producing an intensive and uniform carbon vapour flow. In addition, the melt is used as the hot cathode of the arc discharge struck with the purpose to ionize the vapour flow using the anode. The ion component of the flow is accelerated in the direction towards the substrate that is at a negative or high-frequency potential relative to the discharge plasma. As a result of convective stirring, the melt has practically the same temperature through the entire volume that in combination with the high emission properties of the melt promotes maintaining a uniformly distributed high-current arc discharge without cathode microspots, and producing a dense and uniform flow of highly ionized plasma. During the process, graphite and melt components are fed into the evaporation zone at rates ensuring the stable composition, volume and level of the melt relative to the crucible edge. Compared to the previous technologies, use of this method for producing carbon-containing materials ensures a substantial (more than 10 time) increase of process efficiency and improvement of the quality of the deposited coatings.

A disadvantage of the above method of producing carbon-containing materials in an electron beam device through the transition metal melt is contamination of the condensed materials by components present in the melt composition. Tungsten concentration in the condensate at evaporation of carbon through the melt of transition metal (tungsten) can be from 2.5 up to 10% and higher. It is known that component concentration in the vapour above the melt is proportional to its concentration in the melt. At first, at increase of the heating power, carbon content in the melt rises, while tungsten content in the condensate decreases. Further, despite the change of process parameters in a broad range, melt saturation by carbon is limited, and according to tungsten-carbon constitutional diagram, it is in a narrow range of approximately 2.2 to 3.6% tungsten. Thus, in optimum process modes, we will have such an amount of tungsten in the carbon-containing material condensate.

The closest prior art to the claimed device is a device for electron beam evaporation and condensation of carbon-containing materials in vacuum, which is also disclosed in US Patent # 5296274, cl. B05D 1/00, Movchan B.A. et al. "Method of producing carbon-containing materials by electron beam evaporation of graphite and subsequent condensation", which comprises a vacuum chamber, at least one cylindrical water-cooled crucible with the feed mechanism of evaporable graphite rod, a substrate for vapour flow condensation, a shutter between them, feeder for feeding the transition metal into the melt, which feeder being mounted at the crucible side, electron beam gun to heat and melt said rod and the transition metal sample placed on the rod surface, electron beam gun to heat the substrate, anode, first power source for applying a positive potential to the anode, second power source for applying a potential negative relative to the vapour plasma of the arc discharge or high-frequency potential to the substrate, which in this case is insulated from the chamber. Material which is evaporated is a graphite rod. The shutter between the crucible and substrate is mounted for cutting off the vapour flow at the moment of melt formation and setting the process parameters. Electron beam guns are mounted in the chamber side wall, one of them being used for heating and forming the transition metal melt on the upper face of the graphite rod, and the other being used for heating the substrate, if required. The mechanism for replenishing the melt with the transition metal is mounted on the crucible side. All the vacuum chamber elements and the chamber proper are grounded; and a negative potential is applied to the electron beam gun cathodes. The anode is mounted in the space between the shutter and the crucible, and the device is fitted with the first power source for applying a positive potential to the anode with the purpose of vapour flow ionization using an arc discharge, which is struck between the melt in the crucible and the anode. The device is fitted with the second power source for applying negative or high-frequency potentials relative to the arc discharge vapour plasma to accelerate the vapour flow and improve the conditions for formation of a number of metastable phases in carbon-containing materials. In this case the substrate can be insulated from the chamber for its connection to another power source of constant or high-frequency potentials. For the purpose of evaporation of the second component and its condensation together with carbon on a common substrate, the device is fitted with an additional water-cooled crucible, placed near the first crucible, and the mechanism of feeding the second component, as well as an additional electron beam gun.

The disadvantage of this device consists in that the schematic of directing the vapour flow to the substrate currently implemented in the electron beam unit does not allow to obtain high-purity carbon-containing materials, because the composition of the coating condensed on the substrate copies the composition of the deposited vapour flow, which inevitably incorporates the atoms and clusters of the transition metal.

### The invention essence

The objective of the invention is improvement of the method of producing carbon-containing materials by the process of electron beam evaporation of carbon in vacuum with subsequent condensation on the substrate by addition of the step of vapour flow separation on its path from the evaporation zone to the substrate, this allowing separating and trapping the heavier atoms and clusters of the transition metal, i.e. achieving a purified vapour flow and producing highly pure carbon-containing material on the substrate.

The defined problem is solved by that a process is proposed to produce carbon-containing material by the method of electron beam evaporation of carbon in vacuum with its subsequent condensation on the substrate, which includes placing graphite or graphite and at least one other organic or non-organic component into the vacuum chamber, placing on the consumed graphite surface a sample of at least one transition metal of groups VI - VIII of the periodical system, electron beam heating and melting of the above sample, heating and evaporation of graphite or graphite and at least one other organic or non-organic component through the sample melt, feeding of graphite and sample material, or simultaneous feeding of graphite, sample material and at least one additional organic or non-organic component into the evaporation zone, ionization of the vapour flow in the arc discharge, acceleration of the forming ions, and condensation of carbon-containing material on the substrate in the zone of condensation, in which, **according to the invention,** the initial vapour flow is reflected at least once using a reflector heated to designated temperature to separate the vapour flow atoms by weight, which enables separating and collecting heavier atoms and clusters of transition metals of the sample, which are evaporated from the sample, and the cleaned vapour flow of lighter atoms of carbon, or carbon and at least one additional organic or non-organic component which is used for treating the cleaned vapour flow on its path after separation is directed to the substrate, which is heated or cooled to a temperature, at which the condensation of cleaned vapour flow of graphite or graphite together with atoms of the additional component occurs on the substrate in the form of a carbon-containing material, and at least the reflected cleaned vapour flow is ionized in the arc discharge.

In this case, it is rational using the reflector to change the trajectory of vapour flow on its path from the evaporation zone to the substrate at least once in the specified direction relative to the central axis of the initial vapour flow, which comes to the reflector, in the range from 0 up to 360°.

It is rational to feed into the chamber/condensation zone at least one neutral or reaction gas, which participates in formation of the specified composition and structure of the produced carbon-containing material, which is condensed on the substrate.

It is rational to control the productivity of the process of producing and degree of purity of carbon-containing material by changing the specific power of heating the melt and changing the temperature of at lest one reflector, which reflects the vapour flow, in the range of 1000 - 2500 K.

It is rational to increase the degree of purity of a carbon-containing material by detaching the volume, wherein evaporation occurs, from the volume, wherein condensation takes place.

It is rational to prevent agglomeration (adhesion) of the carbon-containing material particles by means of condensation of the vapour flow on a fluid surface.

The invention is further aimed at solving the problem of improvement of the device for producing carbon-containing materials by the method of electron beam evaporation of carbon or carbon and at least one additional organic or non-organic component in vacuum with subsequent condensation by means of modifying the device design, namely adding at least one reflector for collecting heavy atoms and clusters of transition metal, in order to produce a pure flow of carbon and to condense it on the substrate to produce super pure carbon-containing coatings and synthesis of new nanomaterials, and adding a gas supply inlet valve unit for supplying one or a mixture of several neutral or reaction gases into the chamber, to improve the conditions of formation of a number of metastable phases in carbon-containing materials, particularly at additional evaporation of at least one organic or non-organic component.

The defined aim is achieved by that a device is proposed for producing carbon-containing materials by the method of electron-beam vaporisation of carbon or carbon and at least one additional component of organic or non-organic nature in vacuum and a subsequent condensation thereof, which device includes a vacuum chamber, at least one cylindrical water-cooled crucible with the mechanism of feeding a graphite rode, which is to be evaporated, substrate, first shutter between them, feeder for feeding a transition metal into the melt, said feeder being mounted on the crucible side, an electron-beam gun for heating and melting said rode and a transition metal batch placed on consumed surface of the rode, an electron-beam gun for heating the substrate, an anode, first power source for feeding the positive potential to the anode, second power source for feeding a potential negative relative to the arc discharge vapour plasma or high-frequency potential to the substrate isolated from the chamber, which device, **according to the invention,** additionally incorporates at least one separator placed at an angle to the axis of the initial vapour flow, the separator being disposed in upper part of the vacuum chamber above the cylindrical water-cooled crucible, the substrate being placed aside from the separator, second shutter in the space between the separator and the substrate, additional electron gun for heating the separator, gas supply inlet valve unit for supplying one or a mixture of several neutral or reaction gases into the condensation zone, and an additional anode between the substrate and at least one separator.

It is expedient for the device to comprise additional water-cooled crucible with a feed mechanism of a rode made of the additional component of organic or non-organic nature and electron-beam gun for heating and melting said rode.

It is expedient for the total angle of inclination of one or more separators to be equal from 0 to 360° in order to direct the vapour flow axis in the right direction.

It is rational for the device to further comprise a partition in the vacuum chamber, which partition being destined for separation of the volume, wherein evaporation takes place, from the volume, wherein condensation takes place.

It is rational for the device to further comprise a separate tank in the vacuum chamber, which tank being destined for separation of the volume, wherein evaporation takes place, from the volume, wherein condensation takes place.

It is rational for the substrate to further comprise a reservoir, wherein the fluid surface for condensation is formed.

### Brief description of drawings

To clarify the essence of the invention, given below is an example of the specific embodiment of a device for realization of electron-beam evaporation of carbon in vacuum with separation of the vapour flow and its subsequent condensation to obtain pure carbon-containing materials, and the process is described, which can be implemented using this device. The example is illustrated by drawings which schematically show this device.

Fig. 1 is a schematic of a device to produce carbon-containing materials by the method of electron-beam evaporation of carbon in vacuum, which contains one crucible for disposing graphite and a batch of transition metals.

Fig. 2 is a schematic of a device for producing carbon-containing materials by the method of electron beam evaporation of carbon in vacuum, which comprises two crucibles, one of which accommodates graphite and a batch of transient metals, and the other is designed for evaporation of at least one additional component organic or non-organic nature.

The Figures clarifying the invention, as well as the following examples of concrete embodiments of the method and the device for its realization do not in any way limit the scope of the claims, but just clarify the essence of the invention.

### Detail description of the invention

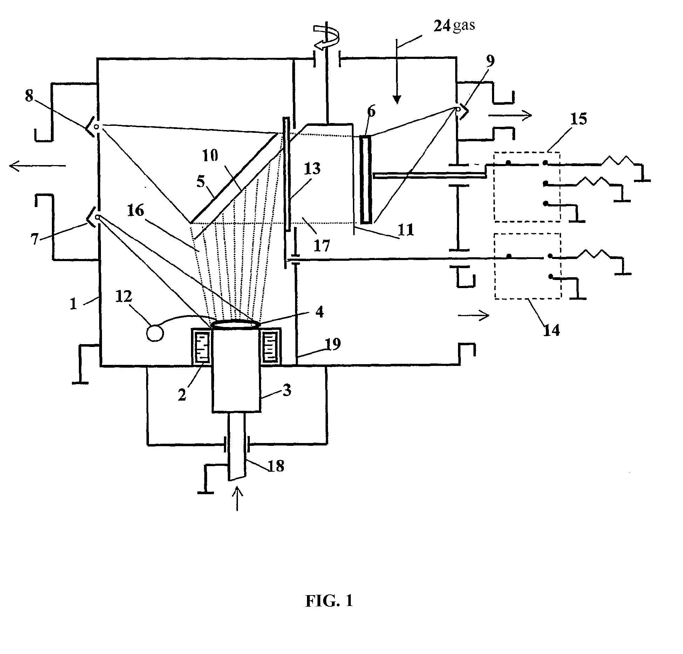

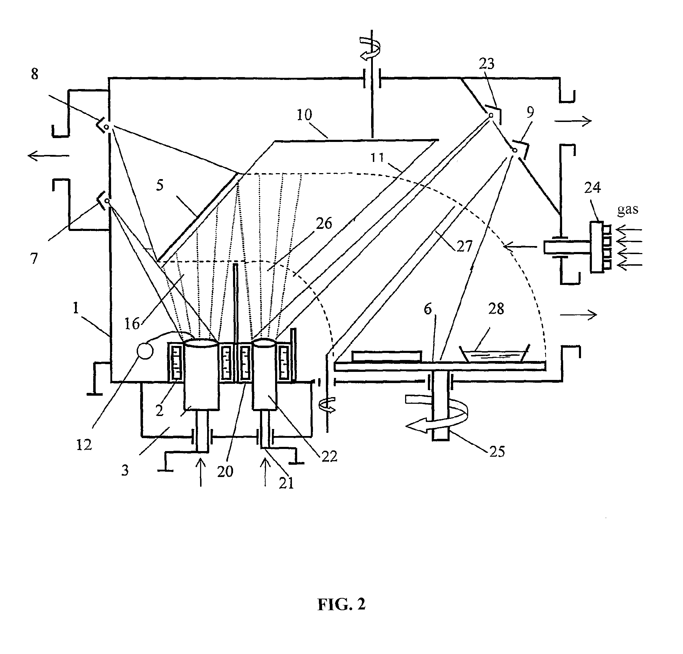

In the device for producing carbon-containing materials by the method of electron-beam evaporation of carbon in vacuum according to the invention (Fig. 1) cylindrical water-cooled crucible 2 is located in the lower part of vacuum chamber 1. Graphite rod 3 is mounted in cylindrical water-cooled crucible 2, with batch 4 of a transition metal of groups VI - VII of the periodic table (for instance W or Mo) or a mixture of at least two transition metals of the above groups placed on the end face of the rod. Separator 5 is mounted at an angle to the axis of the initial vapour flow 16 in the upper part of vacuum chamber 1 above cylindrical water-cooled crucible 2. Substrate 6 is mounted aside from separator 5, so as to meet the condition of angle of incidence of initial vapour flow 16 on separator 5 being equal to angle of reflection of secondary vapour flow 17 from separator 5 to substrate 6. Three electron beam guns 7, 8, 9 are mounted in the side walls of vacuum chamber 1; gun 7 is used for heating and melting of batch 4, gun 8 is used for heating separator 5, gun 9 can be used, if required, for heating the surface of substrate 6. Shutter 10 is mounted in the space between crucible 2 and separator 5, and shutter 11 is the space between separator 5 and substrate 6, respectively. Feeder 12 for feeding the transition metal into the melt is placed aside from crucible 2. All the structural elements of vacuum chamber 1 and vacuum chamber 1 proper are grounded, negative potential being applied to the cathodes of electron beam guns 7, 8 and 9. In addition, anode 13 can be mounted in the space between crucible 2 and shutter 10, or between separator 5 and substrate 6, and the device can be provided with first power source 14 for applying positive potential to anode 13 in order to ionize vapour flows by an arc discharge. To accelerate the vapour flows and improve the conditions for formation of a number of metastable phases in carbon-containing materials the device can be provided with another power source 15 to apply negative or high-frequency potentials relative to the vapour plasma of the arc discharge. In this case, separator 5 and substrate 6 can be insulated from the chamber for their connection to another power source 15 of constant or high-frequency potentials. The device is provided with the mechanism for feeding graphite rod 18. The device chamber can be divided by partition 19 into zones of evaporation and condensation. Moreover, in case of simultaneous evaporation of carbon and another additional component, the device (Fig.2) can be provided with another crucible 20, mechanism 21 for feeding another component 22, electron beam gun 23 for heating and melting of another component 22, gas supply inlet valve unit 24 for supplying one or a mixture of several neutral or reaction gases, shutter 27, and substrate 6 can be located both on the side and at the bottom of chamber 1 and can have additional mechanism of revolution 25, and a reservoir, wherein the fluid surface 28 for condensation is formed.

In such device, the process of producing carbon-containing materials by the method of electron beam evaporation of carbon in vacuum with subsequent condensation is performed as follows. Vacuum chamber 1 (Fig. 1) is pumped down, separator 5 is heated up to the required temperature using electron beam gun 8, substrate 6 is either heated up to the required temperature using electron beam gun 9 or cooled down, for instance, by water. Batch 4 of the transition metal or a mixture of transition metals is placed on the end face of graphite rode 3, which is mounted in cylindrical water-cooled crucible 2, is heated using electron beam gun 7, is melted, and effective evaporation of graphite rod 3 is performed. Presence of the melt of batch 4 on the end face of graphite rod 3 promotes dispersion of graphite particles, which penetrate into it, this leading to an increase of carbon concentration in the melt of sample 4. An intensive and uniform initial vapour flow of carbon 16 is formed as a result of graphite dissolution in the melt, and subsequent predominant evaporation of carbon from the melt, due to the difference in the vapour pressure of carbon and material of batch 4, which is being melted. Then shutters 10 and 11 are opened, and the initial vapour flow of carbon 16 comes to the surface of separator 5, where the heavier atoms and clusters of the transient metal of batch 4 are condensed, and the lighter atoms and clusters of carbon are reflected and directed in the form of secondary carbon vapour flow 17 to substrate 6, where it is condensed in the form of a coating or is synthesized in the form of powderlike carbon materials. During the process, graphite rod 3 and melt components of the melt of batch 4 are fed into the zone of evaporation using the mechanism of feeding graphite rod 18 and mechanism of feeding the components of melt 12 at rates, which provide the stability of the composition, volume and level of the melt relative to edge of crucible 2. In addition, if required, the melt of batch 4 and surface of separator 5 are used as thermocathode of the arc discharge struck with the purpose of ionization of vapour flows 16 and 17, using, for instance, anode 13 and first power source 14 for applying positive potential to anode 13. Ion components of vapour flows 16 and 17 can be accelerated to separator 5 and substrate 6, which are at negative or high-frequency potentials relative to the discharge plasma, which potentials are created by the other power source 15. In the case, if another component is evaporated simultaneously with carbon (Fig. 2), the process runs similar to the above-described, except that another component 22 of organic or non-organic nature is melted simultaneously in additional crucible 20 and is fed by mechanism 21 as the material evaporates. Carbon vapour flow 16 comes to separator 5 and, being reflected from it, meets on its path with vapor flow 26 of another component 22 of organic or non-organic nature and is directed to substrate 6, where under the conditions of heating, cooling and possible feeding of one or several neutral or reaction gases through gas supply inlet valve unit 24 it condenses in the form of coatings or powderlike substance of carbon materials, or synthesis of metastable phases and nanomaterials is performed.

Specific embodiment of the method and device is demonstrated with examples.

### Example 1

The process is implemented in pilot production device UE-150. Graphite rod 3 of 48.5 mm diameter and 110 mm height was placed into cylindrical water-cooled crucible 2 (Fig. 1) of 50 mm inner diameter. Bath 5 of 130 g of tungsten was placed on its upper end face. Vacuum of 1.33- 2.6 x 10⁻² Pa was created in chamber 1. Separator 5 of a molybdenum plate was heated by electron beam gun 8 up to the temperature of 1200° C. Tungsten of batch 5 located on the upper end face of graphite rod 3 was heated by electron beam gun 7 up to melting, resulting formation of the liquid pool of tungsten and developing of the carbon vapour flow. After reaching the mode parameters, shutters 10 and 11 were opened, and the initial carbon vapour flow 16 was directed to the surface of separator 5 mounted at an angle of 45° to the axis of the initial vapour flow, where its separation by the atom weight was performed. Heavier tungsten atoms and clusters were condensed on the separator surface, and lighter carbon atoms and clusters after elastic collision were reflected in the form of secondary vapour flow 17 of carbon and directed to the surface of substrate 6, where they were condensed on the substrate heated up to temperature of 500° C by the radiation from separator 5. After operation for 15 min shutters 10 and 11 were closed, power of electron beam guns 7 and 8 was switched off, and the process was completed. The distance between the surface of the melt of sample 5 in crucible 2 and center of separator 5 was equal to 250 mm. The distance between center of separator 5 and substrate 6 was 350 mm. Beam current of gun 7 was 1.3 A, accelerating voltage being 24 kV. Rate of carbon evaporation was 2.47 g/min.

Content of elements on the surface of carbon coatings, which have condensed on the separator and the substrate, was determined using X-ray INCA-200 Energy attachment for scanning electron microscope CamScan. Content of tungsten on the separator was 6.49% and on the substrate 0.22 %, respectively. Thus, the method of vapour flow separation allowed a considerable, by more than an order of magnitude, lowering of tungsten content in the final carbon material.

### Example 2

Conditions of realization of the method and technology steps are the same as in example 1 (Fig. 1), except for temperature parameters of heating of the separator and liquid pool of the melt. Separator was heated by electron beam gun 8 up to the temperature of 1300° C. Beam current of electron beam gun 7 for melt heating was increased to 1.7 A. Rate of carbon evaporation was 8.22 g/min.

Tungsten content in the separator was 13.36% and 0% on the substrate, respectively. Thus, the method of vapour flow separation allows completely removing the impurities of the transition metal of the batch from the carbon-containing material.

### Example 3

Conditions of realization of the process and technology steps are the same as in example 2 (Fig. 1), except that simultaneously with carbon evaporation an ingot of another component 22 - titanium (Fig. 2) of 48.5 mm diameter and 200 mm length was evaporated from an additional water-cooled crucible 20 of 50 mm diameter. The ingot was fed by mechanism 21. Beam current of gun 23 was 1.3 A, accelerating voltage being 24 kV. Initial vapour flows of carbon 16 was directed to separator 5, mounted at an angle of 30° to the axis of the initial vapour flow and heated up to the temperature of 1500 C, and, being reflected from it and meeting on its path titanium vapour flow 26, was directed to substrate 6 heated up to the temperature of 700 C, where argon was supplied simultaneously using gas supply inlet valve unit 24. After opening shutters 10 and 27 the deposition process was conducted for 30 minutes on substrate 6, which was rotated by mechanism 25 for averaging the titainium content over the area of substrate 6. The distance between the center of separator 5 and crucibles 2 and 20 was 250 mm, and that between separator 5 and substrate 6 was 350 mm.

Tungsten content on separator 5 was 4.84%, and in the condensate on substrate 6 it was 0%, i.e. the carbon material was cleaned from heavy tungsten atoms by separation of the vapour flow. X-ray structure analysis revealed the presence of titanium carbide and free carbon in the coating. No free titanium was found.

### Example 4

Conditions of realization of the process and technology steps are the same as in example 1 (Fig. 1), except for the temperature of substrate heating. Glass substrate was heated up to the temperature of 400° C.

Carbon-containing material was condensed on glass in the form of a thin dense shiny film with 0.23% tungsten.

### Example 5

Conditions for realization of the method and techniques are the same as in example 2 (Fig. 1), except for the temperature of substrate heating. Copper water-cooled substrate was at the temperature of 30 - 50° C during the process.

Carbon-containing material was condensed in the form of a dispersed, partially falling off powder of pure carbon with nano-sized structure without any tungsten content.

### Example 6

Conditions for realization of the method and techniques are the same as in example 3 (Fig. 2), except for the surface of condensation. A reservoir with oleic acid was disposed on the copper water-cooled substrate, which has temperature of 50 - 100° C during the process.

Carbon material was condensed in a form of nano-sized particles on the liquid surface.

### Industrial applicability

The invention can be used in tool industry, electronics, medicine, as well as in producing especially pure carbon-containing materials and for synthesizing novel nanomaterials.

## Claims

1. A method for producing a carbon-containing material by carbon electron-beam vaporisation in a vacuum and a subsequent condensation thereof on a substrate, which method comprises placement of graphite or graphite and at least one additional component of organic or non-organic nature in the vacuum chamber, placing a batch of at least one transition metal of VI-VIII groups of periodic system on the consumed graphite surface, electron-beam heating and melting of the said batch, heating and evaporation of graphite or graphite and at least one additional component of organic or non-organic nature through the batch melt, feeding graphite, batch material, or simultaneous feeding graphite, batch material and at least one additional component of organic or non-organic nature into the evaporation zone, vapour flow ionization in the arc discharge, acceleration of the forming ions, and condensation of carbon-containing material on a substrate in a condensation zone, **characterized in that** the carbon vapour flow is reflected by a separator heated to specified temperature at least once on its path from the evaporation zone to the substrate in order to separate vapour flow atoms by masses and to capture and collect heavier atoms and clusters of transition metals, which evaporate from the batch, and the cleaned vapour flow containing lighter atoms of carbon or carbon and at least one additional component of organic or non-organic nature, which additional component being intended to treat said cleaned vapour flow in its part after separation, is directed to the substrate, which is heated or cooled to a temperature at which condensation of cleaned vapour flow of graphite or graphite and additional component atoms in the form of carbon-containing material proceeds on the substrate, at least the reflected cleaned vapour flow being ionized in the arc discharge.

2. The method according to claim 1, **characterized in that** the vapour flow is reflected by the separator at least once on it path from the vaporization zone to the substrate in order to change the flow path in the specified direction relative to the central axis of the initial vapour flow in the range from 0 to 360⁰.

3. The method according to any of claims 1 - 2, **characterized in that** at least one neutral or reaction gas, which takes part in formation of a certain composition and structure of the produced carbon-containing material, which is condensed on the substrate, is supplied into the chamber/zone of condensation.

4. The method according to any of claims 1 - 3, **characterized in that** specific power of melt heating is changed and the temperature of at least one separator, which reflects the vapour flow, is changed in the range of 1000 - 2500 K, whereby regulation of the efficiency of the process of producing and degree of purity of carbon-containing material is carried out.

5. The method according to any of claims 1 - 4, **characterized in that** the volume, wherein evaporation takes place, is separated from the volume, wherein condensation takes place, whereby the degree of purity of carbon-containing materials is increased.

6. The method according to any of claims 1 - 5, **characterized in that** the vapour flow condensation is carried out on a fluid surface, whereby agglomeration (adhesion) of carbon-containing material particles is prevented.

7. A device for producing carbon-containing materials by the method of electron-beam evaporation of carbon or carbon and at least one additional component of organic or non-organic nature in vacuum with subsequent condensation, which device comprises vacuum chamber, at least one cylindrical water-cooled crucible with a feed mechanism of a graphite rode subject to evaporation, a substrate, first shutter between them, feeder for feeding transition metal into the melt, which feeder being mounted aside from the crucible, electron beam gun for heating and melting said rode and the transition metal batch placed on the rode consumed surface, electron beam gun for heating the substrate, an anode, first power source for applying a positive potential to the anode, second power source for applying a potential negative relative to the arc discharge vapour plasma or high-frequency potential to the substrate, which substrate being insulated from the chamber, **characterized in that** the device further comprises at least one separator positioned at an angle to the axis of the initial vapour flow, said separator being disposed in upper part of the vacuum chamber above the water-cooled cylindrical crucible, the substrate being placed aside from the separator, second shutter in the space between the separator and the substrate, additional electron gun for heating the separator, gas supply inlet valve unit for supplying one or a mixture of several neutral or reaction gases into the condensation zone, the anode being located between the substrate and at least one separator.

8. The device according to claim 7, **characterized in that** the device comprises additional water-cooled crucible with a feed mechanism of a rode made of the additional component of organic or non-organic nature and electron-beam gun for heating and melting said rode.

9. The device according to any of claims 7 - 8, **characterized in that** the total angle of inclination of separator/separators is equal from 0 to 360⁰ in order to direct the axis of the vapour flow in the required direction.

10. The device according to claims 7-9, **characterized in that** the device further comprises a partition in the vacuum chamber, which partition being destined for separation of the volume, wherein evaporation takes place, from the volume, wherein condensation takes place.

11. The device according to claims 7-10, **characterized in that** the device further comprises a separate tank in the vacuum chamber, which tank being destined for separation of the volume, wherein evaporation takes place, from the volume, wherein condensation takes place.

12. The device according to claims 7-11, **characterized in that** the substrate further comprises a reservoir, wherein the fluid surface for condensation is formed.
